## Europäisches Patentamt
## European Patent Office
## Office européen des brevets

(19)

(11) Veröffentlichungsnummer: **0 220 645**
**B1**

(12) **EUROPÄISCHE PATENTSCHRIFT**

(45) Veröffentlichungstag der Patentschrift:
12.09.90

(51) Int. Cl.⁵: **G03F 7/022, G03F 7/16**

(21) Anmeldenummer: 86114510.0

(22) Anmeldetag: 20.10.86

(54) Strahlungsempfindliches, positiv-arbeitendes Gemisch und hieraus hergestelltes Photoresistmaterial.

(30) Priorität: 28.10.85 US 791880

(43) Veröffentlichungstag der Anmeldung:
06.05.87 Patentblatt 87/19

(45) Bekanntmachung des Hinweises auf die Patenterteilung:
12.09.90 Patentblatt 90/37

(84) Benannte Vertragsstaaten:
AT CH DE FR GB IT LI NL

(56) Entgegenhaltungen:
EP-A- 0 051 185
EP-A- 0 164 083
EP-A- 0 164 248
EP-A- 0 178 594
EP-A- 0 195 315
US-A- 4 550 069

CHEMICAL ABSTRACTS, Band 48, Nr. 22, 25.
November 1954, Zusammenfassung Nr. 13951f,
Columbus, Ohio, US; V.K. ROWE et al.: "Toxicology of
mono,-di-, and tri-propylene glycol methyl ethers", &
ARCH. IND. HYG. OCCUPATIONAL
MED. 9, 509-25 (1954)

(73) Patentinhaber: HOECHST CELANESE CORPORATION,
Route 202-206 North, Somerville, N.J. 08876(US)

(72) Erfinder: Durham, Dana, RD No. 1 Box 372, Bloomsbury
New Jersey 08804(US)

(74) Vertreter: Euler, Kurt Emil, Dr. et al, KALLE
Niederlassung der Hoechst AG
Rheingaustrasse 190 Postfach 3540,
D-6200 Wiesbaden 1(DE)

## Beschreibung

Die vorliegende Erfindung betrifft ein strahlungsempfindliches, positiv-arbeitendes Gemisch, das im wesentlichen aus mindestens einem wasserunlöslichen, in wäßrigalkalischen Lösungen löslichen Novolak- oder Polyvinylphenolharz als Bindemittel, mindestens einem o-Chinondiazid als lichtempfindlicher Verbindung und einem Propylenglykolalkyletheracetat enthaltenden Lösemittel besteht. Die Erfindung betrifft auch ein hieraus hergestelltes Photoresistmaterial.

Die Herstellung von positiv-arbeitenden Photoresistansätzen ist bekannt und wird zum Beispiel in US-A 3,666,473, US-A 4,115,128 und US-A 4,173,470 beschrieben. Dabei handelt es sich um alkalilösliche Phenolformaldehyd-Novolakharze in Verbindung mit lichtempfindlichen Stoffen, gewöhnlich substituierten Naphthochinondiazidverbindungen. Die Harze und lichtempfindlichen Stoffe werden in einem organischen Lösemittel oder Lösemittelgemisch gelöst und als dünne Schicht bzw. Beschichtung auf einen für den vorgesehenen Verwendungszweck geeigneten Schichtträger aufgebracht.

Die Novolakharzkomponente dieser Photoresistansätze ist in wäßrig-alkalischen Lösungen löslich, wobei aber die lichtempfindliche Naphthochinonverbindung als Inhibitor auf das Harz wirkt. Wenn jedoch bestimmte Bereiche des beschichteten Trägers mit aktinischer Strahlung belichtet werden, erfährt die lichtempfindliche Verbindung eine durch die Bestrahlung induzierte strukturelle Umwandlung, und die belichteten Bereiche der Beschichtung werden löslicher als die unbelichteten. Durch diesen Löslichkeitsunterschied lösen sich die belichteten Bereiche der Photoresistschicht beim Eintauchen des Schichtträgers in eine alkalische Entwicklerlösung, während die unbelichteten Bereiche weitgehend unbeeinträchtigt bleiben, so daß auf dem Träger ein positives Reliefbild entsteht.

In den meisten Fällen wird der entwickelte Schichtträger mit einer Ätzlösung oder Gasplasma behandelt. Dabei schützt die Photoresistschicht die beschichteten Bereiche des Trägers vor dem Ätzmittel, so daß dieses nur die freigelegten Bereiche ätzen kann. Das sind bei einem positiv arbeitenden Resist die mit aktinischer Strahlung belichteten Bereiche. Es kann also auf dem Schichtträger ein Ätzmuster entsprechend dem Bild der Maske, Schablone usw. erzeugt werden, die vor dem Entwickeln zur Herstellung bestimmter Belichtungsmuster auf dem beschichteten Träger verwendet wurde.

Das nach dem oben beschriebenen Verfahren hergestellte Reliefbild aus Photoresist auf dem Schichtträger eignet sich für verschiedene Anwendungszwecke, zum Beispiel als Maske oder Bild, beispielsweise bei der Herstellung von Halbleiterbauelementen in der Mikroelektronik.

Für die produktionstechnische Nutzung eines Photoresists wichtige Eigenschaften sind die folgenden: Lichtempfindlichkeit, Entwicklungskontrast, Bildauflösung und Haftung des Resists auf dem Schichtträger.

Eine erhöhte Lichtempfindlichkeit ist wichtig für einen Photoresist, insbesondere wenn er für Anwendungen eingesetzt wird, bei denen mehrere Belichtungen erforderlich sind, z.B. bei der Erzeugung von Mehrfachbildern durch ein Wiederholungsverfahren oder in Fällen, in denen Licht mit abgeschwächter Intensität verwendet wird, z.B. in der Projektionsbelichtungstechnik, bei der das Licht eine Reihe von Objektiven und monochromatischen Filtern durchläuft. Eine erhöhte Lichtempfindlichkeit ist also ganz besonders wichtig für ein Resistgemisch, das in Verfahren eingesetzt wird, bei denen Mehrfachbelichtungen durchgeführt werden müssen, um eine Maske oder eine Serie von Schaltbildern auf einem Träger zu erzeugen. Optimale Bedingungen ergeben sich durch eine gleichbleibende Entwicklungstemperatur und -zeit bei einer bestimmten Entwicklungsart sowie durch ein Entwicklersystem, das so ausgewählt ist, daß ein vollständiges Ausentwickeln der belichteten Resistbereiche erreicht und gleichzeitig der Dickenverlust der unbelichteten Resistbereiche bei höchstens etwa 10 % der anfänglichen Dicke gehalten wird.

Unter Entwicklungskontrast ist der Unterschied zwischen dem Prozentanteil des Schichtverlusts in den belichteten Bereichen nach dem Entwickeln und dem Prozentanteil des Schichtverlusts in den unbelichteten Bereichen zu verstehen. Normalerweise wird ein resistbeschichteter Träger nach dem Belichten so lange entwickelt, bis die Schicht sich in den belichteteen Bereichen im wesentlichen vollständig abgelöst hat. Der Entwicklungskontrast kann daher dadurch bestimmt werden, daß nach dem vollständigen Ablösen der belichteten Schichtbereiche einfach der Prozentanteil des Schichtverlusts in den unbelichteten Bereichen gemessen wird.

Unter Bildauflösung des Resists versteht man die Fähigkeit eines Resistsystems zur Wiedergabe der kleinsten, im gleichen Abstand voneinander angeordneten Linienpaare und der zugehörigen Zwischenräume einer für die Belichtung verwendeten Maske, mit einem hohen Grad an Flankensteilheit des Bildes in den ausentwickelten belichteten Zwischenräumen.

Für viele technische Anwendungen, insbesondere für die Herstellung von Halbleiterbauelementen in der Mikroelektronik, muß ein Photoresist einen hohen Auflösungsgrad aufweisen, wenn er sehr kleine Linien- und Zwischenraumbreiten (in der Größenordnung von 1 μm) wiedergeben soll.

Die Fähigkeit eines Resists zur Wiedergabe sehr kleiner Abmessungen in der Größenordnung von 1 μm und darunter ist bei der Herstellung von VLSI-Schaltungen auf Siliziumchips und ähnlichen Komponenten von größter Bedeutung. Die Schaltungsdichte auf einem solchen Chip kann nur durch eine Steigerung des Auflösungsvermögens des Resists - vorausgesetzt, es wird mit photolithographischen Verfahren gearbeitet - erhöht werden. Obwohl negativ arbeitende Photoresists, bei denen die belichteten

2

Bereiche der Resistschicht im Entwickler unlöslich sind und die unbelichteten Bereiche vom Entwickler abgelöst werden, in der Halbleiterindustrie in großem Umfang für diesen Zweck verwendet werden, haben doch die positiv-arbeitenden Photoresists von ihrer Natur her eine höhere Bildauflösung und werden als Ersatz für die negativ-arbeitenden Resists eingesetzt.

Beim Einsatz von herkömmlichen positiv-arbeitenden Photoresists für die Herstellung von Halbleiterbauelementen in der Mikroelektronik besteht die Schwierigkeit, daß die positiv-arbeitenden Resists im allgemeinen eine geringere Lichtempfindlichkeit haben als die negativ-arbeitenden Resists.

In der Vergangenheit wurden bereits verschiedene Versuche unternommen, um die Lichtempfindlichkeit positiv-arbeiten-der Photoresistgemische zu verbessern. In US-A 3,666,473 wird zum Beispiel ein Gemisch aus zwei Phenolformaldehyd-Novolaken zusammen mit einer üblichen lichtempfindlichen Verbindung verwendet, wobei diese Novolakharze durch ihre Lösungsgeschwindigkeit in alkalischen Lösungen eines bestimmten pH-Werts und durch ihren Trübungspunkt definiert sind.

In US-A 4,115,128 wird zur Steigerung der Lichtempfindlichkeit dem Phenolharz und dem als lichtempfindliche Verbindung verwendeten Naphthochinondiazid eine dritte Komponente, nämlich ein zyklisches Anhydrid einer organischen Säure, hinzugefügt.

Es ist auch bekannt Photoresistgemische einzusetzen, die Propylenglykolalkyletheracetat enthalten (US-A- 4,550,069). Ferner ist bekannt (DE-A- 3 421 160) in entsprechenden Gemischen Mono-($C_1$-$C_4$)-alkylglykolether von 1,2-Propandiol einzusetzen. Diese Komponenten wirken als Lösemittel für das Bindemittel und die lichtempfindliche Verbindung und sie erleichtern so das Aufbringen des Resists auf den Schichtträger. Die bekannten Verbindungen besitzen eine geringe Toxizität gegenüber denen, die üblicherweise Verwendung finden. Es hat sich jedoch gezeigt, daß die bekannten, als Lösemittel eingesetzten Verbindungen spezielle Geruchsbelästigungen mit sich bringen.

Das Dokument EP-A 0 195 315 gehört zum Stand der Technik gemäß Artikel 54 (3) EPa. Es beschreibt ein Gemisch ohne spezielle Angaben über das Verhältnis der Lösungsmittel in einem Mischungsverhältnis zwischen 10:1 und 1:10.

Es war Aufgabe der vorliegenden Erfindung ein strahlungsempfindliches, positiv-arbeitendes Gemisch zu schaffen, das eine geringere Geruchsbelästigung für das Bedienungspersonal aufweist als herkömmliche Gemische und dabei in bezug auf die Lichtempfindlichkeit, Erosionsrate des Resists, Plasmaätzrate und den Entwicklungskontrast unveränderte oder gar verbesserte Eigenschaften besitzen.

Die Lösung dieser Aufgabe geht von einem strahlungsempfindlichen, positiv-arbeitenden Gemisch der eingangs genannten Art aus und sie ist dadurch gekennzeichnet, daß das Lösemittel ein Gemisch aus Propylenglykol-($C_1$-$C_4$)-alkyletheracetat und Propylenglykol-($C_1$-$C_4$)-alkylether enthält oder daraus besteht. In bevorzugter Ausführungsform ist ein Lösemittel vorhanden, das ein Gemisch aus Propylenglykolmethyletheracetat und Propylenglykolmethylether enthält oder daraus besteht. Das Gemisch ist insbesondere in einer Menge von etwa 5 bis 100 Gewichtsprozent, bezogen auf das Lösemittel, vorhanden.

Überraschenderweise wurde gefunden, daß ein derartiger verbesserter Resist hergestellt werden kann, indem das Novolak- oder Polyvinylphenolharz als Bindemittel und das o-Chinondiazid als lichtempfindliche Verbindung mit einem Lösemittelgemisch aus einer Propylenglykoletheracetat- und einer Propylenglykolalyklether-Komponente gemischt werden.

Lichtempfindliche Gemische, in denen nur eine der beiden erfindungsgemäßen Komponenten Propylenglykolalkyletheracetat oder Propylenglykolalkylether enthalten ist, weisen folgenden Nachteil auf: Der Einsatz von Propylenglykolmethyletheracetat (PGMEA) bringt etwa für die Hälfte des mit dieser Substanz in Berührung kommenden Personenkreises eine äußerst unangenehme Geruchsbelästigung mit sich, wobei überwiegend Frauen über Beschwerden klagen. Auch die Verwendung von Propylenglykolmethylether (PGME) bedeutet für etwa die Hälfte des mit dieser Substanz hantierenden Personenkreises eine starke Geruchsbelästigung, wobei sich in diesem Fall überwiegend Männer beklagen. Dabei ist es jedoch so, daß diejenigen, die den Geruch von PGMEA überaus lästig finden, PGME als angenehm oder wenigstens nicht störend riechend empfinden und umgekehrt. Wenn nun Gemische dieser Lösemittel, also von PGMEA und PGME, in einem Mischungsverhältnis von 1 : 1 eingesetzt werden, klagt keine der betroffenen Personengruppen über nennenswerte Beschwerden. Daher können Photoresists, für deren Herstellung Gemische von PGMEA und PGME verwendet wurden, als eine Klasse von Photoresists mit verminderter Geruchsbelästigung bezeichnet werden.

Die Herstellung von Gemisch und Material erfolgt in der Weise, daß zunächst ein Gemisch aus mindestens einem Harz aus der Gruppe der Novolake und Polyvinylphenole und mindestens einer lichtempfindlichen o-Chinondiazidverbindung in einem Propylenglykolalkylether und Propylenglykolalkyletheracetat enthaltenden Lösemittelgemisch gebildet wird, das Gemisch auf einen geeigneten Schichtträger aufgetragen und getrocknet wird, so daß man eine im wesentlichen unklebrige Schicht mit einem Restlösemittelanteil von 1 bis 30 %, bezogen auf das Trockenschichtgewicht, erhält. Die erhaltene Schicht wird mittels geeigneter aktinischer Strahlung bildmäßig belichtet und entwickelt, wodurch die belichteten Stellen mit einem wäßrig-alkalischen Entwickler entfernt werden.

Die erfindungsgemäßen Photoresistgemische weisen nicht nur eine ausgezeichnete Lichtempfindlichkeit im Vergleich mit bekannten positiv-arbeitenden Photoresists auf, sondern zeichnen sich auch durch einen hohen Bildauflösungsgrad, einen guten Entwicklungskontrast und gute Haftungseigenschaften aus. Mit diesen Eigenschaften unterscheiden sie sich deutlich von einigen bekannten Resists, die zwar eine mäßig gesteigerte Lichtempfindlichkeit besitzen, wobei diese Verbesserung allerdings auf Kosten von Auflösungsvermögen und Kontrast erzielt wird. Außerdem riecht das erfindungsgemäße Gemisch besser als bekannte Photoresistgemische und ist weniger toxisch, d.h. umweltfreundlicher in seiner Anwendung.

Die Produktion von Novolakharzen, die für die Herstellung von lichtempfindlichen Gemischen verwendet werden können, ist bekannt. Ein Verfahren zur Herstellung dieser Novolake ist in "Chemistry and Application of Phenolic Resins" (Chemie und Anwendung von Phenolharzen), von A. Knop und W. Scheib, Springer Verlag, New York, 1979, Kapitel 4, beschrieben. Polyvinylphenole sind beispielsweise in US-A 3,869,292 und US-A 4,439,516 beschrieben. Dem Fachmann ist auch die Verwendung von o-Chinondiaziden bekannt, wie in "Light Sensitve Systems" von J. Kosar, John Wiley & Sons, New York, 1965, Kapitel 7.4, beschrieben. Diese lichtempfindlichen Verbindungen, die einen Bestandteil innerhalb der vorliegenden Erfindung bilden, gehören zur Gruppe der substituierten lichtempfindlichen Naphthochinondiazide, wie sie üblicherweise in positiv-arbeitenden Photoresistansätzen verwendet werden. Solche Lichtempfindlichkeit verleihenden Verbindungen sind zum Beispiel aus US-A 2,797,213, US-A 3,106,465, US-A 3,148,983, US-A 3,130,047, US-A 3,201,329, US-A 3,785,825 und US-A 3,802,885 bekannt. Geeignete lichtempfindliche Verbindungen sind zum Beispiel mit phenolischen Verbindungen, wie Hydroxybenzophenonen, kondensiertes 1,2-Naphthochinondiazid-(2)-5-sulfonylchlorid und 1,2-Naphthochinondiazid-(2)-4-sulfonylchlorid.

In bevorzugter Ausführung liegt der Gehalt an festen Bestandteilen des Photoresistgemischs, d.h. an Bindemittel und Diazid, vorzugsweise bei etwa 15 bis 99 Gewichtsprozent an Bindemittel und etwa 1 bis 85 Gewichtsprozent an o-Chinondiazid. Insbesondere ist das Bindemittel in einem Anteil von etwa 50 bis 90 Gewichtsprozent, und ganz besonders bevorzugt etwa 65 bis 85 Gewichtsprozent, bezogen auf das Gewicht der festen Bestandteile des Photoresists, in dem Gemisch enthalten. Der Anteil an Diazid liegt insbesondere bei etwa 10 bis 50 Gewichtsprozent und ganz besonders bevorzugt bei etwa 15 bis 35 Gewichtsprozent, bezogen auf das Gewicht der festen Bestandteile des Photoresistgemischs. Zur Herstellung des Photoresistgemisches werden das Bindemittel und das Diazid so mit einem Lösemittelgemisch aus Propylenglykolalkylether und Propylenglykolalkyletheracetat gemischt, daß das Lösemittelgemisch in einem Anteil von etwa 40 bis 90 Gewichtsprozent, vorzugsweise von etwa 60 bis 83 Gewichtsprozent, und insbesondere von etwa 65 bis 70 Gewichtsprozent, jeweils bezogen auf das Gewicht des gesamten Resistgemischs, vorhanden ist. Dabei kann das Gewichtsverhältnis von PGMEA zu PGME in Abhängigkeit von den jeweiligen anwendungstechnischen Erfordernissen in weiten Grenzen variiert werden. Beispielsweise kann das Verhältnis zwischen 1:20 und 20:1 betragen. Bevorzugt beträgt das Mischungsverhältnis von PGMEA zu PGME zwischen 10:1 und 1:10, insbesondere zwischen 6:4 und 4:6. Ganz besonders bevorzugt ist ein Mischungsverhältnis von etwa 1:1 Gewichtsteilen. Der Lösung aus Bindemittel, lichtempfindlicher Verbindung und Lösemittelgemisch können vor dem Aufbringen auf einen Schichtträger noch Zusätze, wie z.B. Farbmittel, Farbstoffe, Verlaufmittel, Weichmacher, Haftvermittler, Entwicklungsbeschleuniger, weitere Lösemittel und Tenside, z.B. nicht-ionische Tenside, zugegeben werden.

Farbstoffe, die als Zusätze für die erfindungsgemäßen Photoresistgemische verwendet werden können, sind zum Beispiel Methylviolett 2B (C.I. 42 535), Kristallviolett (C.I. 42 555), Malachitgrün (C.I. 42 000), Victoriablau B (C.I. 44 045) und Neutralrot (C.I. 50 040). Diese Farbstoffe werden in einer Menge von 1 bis 10 Gewichtsprozent, bezogen auf das Gesamtgewicht von Bindemittel und lichtempfindlicher Verbindung, zugesetzt. Die Farbstoffzusätze verringern die Rückstreuung von Licht vom Schichtträger und tragen so zu einer verbesserten Bildauflösung bei.

Verlaufmittel können in einer Menge bis zu 5 Gewichtsprozent, bezogen auf das Gesamtgewicht von Bindemittel und lichtempfindlicher Verbindung, eingesetzt werden.

Geeignete Weichmacher sind zum Beispiel Phosphorsäuretri-(β-chlorethyl)-ester, Stearinsäure, Dicampher, Polypropylen, Acetalharze, Phenoxyharze und Alkydharze, die in Anteilen von 1 bis 10 Gewichtsprozent, bezogen auf das Gesamtgewicht von Bindemittel und lichtempfindlicher Verbindung, zugesetzt werden können. Die Weichmacherzusätze verbessern die Beschichtungseigenschaften des Gemischs und ermöglichen das Auftragen in einer glatten und gleichmäßig dicken Schicht auf den Schichtträger.

Geeignete Haftvermittler sind zum Beispiel β-(3,4-Epoxycyclohexyl)-ethyltrimethoxysilan, p-Methyldisilanmethylmethacrylat, Vinyltrichlorsilan und γ-Aminopropyltriethoxysilan in einem Anteil bis zu 4 Gewichtsprozent, bezogen auf das Gesamtgewicht von Bindemittel und lichtempfindlicher Verbindung.

Als Entwicklungsbeschleuniger können beispielsweise Pikrinsäure, Nicotinsäure oder Nitrozimtsäure in einem Anteil bis zu 20 Gewichtsprozent, bezogen auf das Gesamtgewicht von Bindemittel und lichtempfindlicher Verbindung, zugegeben werden. Diese Beschleuniger führen dazu, daß die Löslichkeit der Photoresistschicht sowohl in den belichteten als auch in den unbelichteten Bereichen zunimmt, und sie werden deshalb bei solchen Anwendungen eingesetzt, bei denen es in erster Linie auf die Entwicklungsgeschwindigkeit ankommt, auch wenn dabei evtl. ein gewisser Grad an Kontrast geopfert wird; denn während die belichteten Bereiche der Photoresistschicht durch den Zusatz von Beschleunigern vom Entwickler schneller gelöst werden, bewirken die Entwicklungsbeschleuniger gleichzeitig auch einen größeren Verlust an Photoresistschicht aus den unbelichteten Bereichen.

Geeignete zusätzliche Lösemittel sind zum Beispiel Xylol, Butylaceat und Ethylenglykolmethyletheracetat, die in einem Anteil bis zu 95 Gewichtsprozent in dem gesamten Lösemittel anwesend sein können; vorzugsweise werden jedoch in dem Gemisch keine zusätzlichen Lösemittel verwendet.

Als nicht-ionische Tenside können zum Beispiel Nonylphenoxy-poly(ethylenoxy)-ethanol, Octylphenoxy(ethylenoxy)-ethanol, und Dinonylphenoxy-poly(ethylenoxy)ethanol in einem Anteil bis zu 10 Gewichtsprozent, bezogen auf das Gesamtgewicht von Bindemittel und lichtempfindlicher Verbindung, verwendet werden.

Die fertige Photoresistlösung kann nach einem der in der Photoresisttechnik üblichen Verfahren, wie Tauchen, Sprühen und Aufschleudern, auf einen Träger aufgebracht werden. Für das Aufschleudern kann zum Beispiel der Prozentanteil an Feststoffen in der Resistlösung so eingestellt werden, daß sich in Abhängigkeit von der im Einzelfall verwendeten Aufschleudergeschwindigkeit und der für den Aufschleudervorgang angesetzten Zeitspanne eine Beschichtung in der gewünschten Dicke ergibt. Beispiele für geeignete Trägermaterialien sind: Silicium, Aluminium oder polymere Harze, Siliciumdioxid, dotiertes Siliciumdioxid, Siliciumnitrid, Tantal, Kupfer, polykristallines Silicium (polysilicon), Keramik und Aluminium/Kupfer-Legierungen.

Dementsprechend betrifft die vorliegende Erfindung auch ein strahlungsempfindliches, positiv-arbeitendes Photoresistmaterial aus einem Schichtträger und einer darauf befindlichen Photoresistbeschichtung, die im wesentlichen aus einem Gemisch von mindestens einem wasserunlöslichen, in wäßrig-alkalischen Lösungen löslichen Novolak- oder Polyvinylphenolharz als Bindemittel, mindestens einem o-Chinondiazid als lichtempfindlicher Verbindung und einem Propylenglykolalkyletheracetat enthaltenden Lösemittel besteht, dadurch gekennzeichnet, daß die Beschichtung durch Vortrocknen eines Gemisches hergestellt wurde, das als Lösemittel ein Gemisch aus Propylenglykol($C_1$-$C_4$)-alkyletheracetat und Propylenglykol-($C_1$-$C_4$)-alkylether enthält oder daraus besteht.

Die Photoresistlösungen eignen sich insbesondere zum Auftragen auf Silicium-Wafer, die eine Schicht aus thermisch gezüchtetem Siliciumdioxid tragen, wie sie bei der Herstellung von Mikroprozessoren und anderen in der Mikroelektronik verwendeten Halbleiterbauelementen verwendet werden. Ebenso kann auch ein Wafer aus Aluminium mit einer Aluminiumoxidschicht eingesetzt werden. Der Schichtträger kann auch aus verschiedenen polymeren Harzen, insbesondere aus transparenten Polymeren, wie zum Beispiel Polyestern, bestehen.

Nach dem Auftragen der Photoresistlösung auf den Schichtträger wird der Träger einer Vortrocknung bei etwa 20 bis 110 °C unterworfen. Diese Wärmebehandlung erfolgt, um die Restlösemittelkonzentration im Photoresist durch Verdampfen zu verringern und zu steuern, ohne daß es dabei zu einer merklichen thermischen Zersetzung der lichtempfindlichen Verbindung kommt. Es wird im allgemeinen angestrebt, den Gehalt an Lösemitteln auf ein Minimum zu senken, und diese erste Wärmebehandlung wird daher so lange fortgeführt, bis die Lösemittel im wesentlichen verdampft sind und eine dünne Schicht aus Photoresistgemisch, deren Dicke etwa 1 µm beträgt, auf dem Schichtträger zurückbleibt. Bevorzugt liegt die Temperatur bei dieser Behandlung zwischen etwa 50 und 105 °C, insbesondere zwischen etwa 80 und 105°C. Dieser Behandlungsschritt ist dann beendet, wenn sich der Lösemittelanteil nicht mehr nennenswert verringert. Die Wahl der jeweiligen Temperatur und Zeitdauer hängt von den vom Anwender gewünschten Resisteigenschaften, der verwendeten Ausrüstung und den ökonomisch erwünschten Beschichtungszeiten ab. Bei einer Behandlung mit Hilfe von Heizplatten, sogenannten "Hot Plates", ist eine Dauer von bis zu 3 Minuten, bevorzugt bis zu 1 Minute, wirtschaftlich sinnvoll. Beispielsweise kann die Vortrocknung innerhalb von 30 Sekunden bei 90 °C durchgeführt werden. In einem Umluftschrank beträgt die Dauer des Verdunstungsvorgangs zwischen 15 Minuten und 60 Minuten oder mehr. Die aufgebrachte Schicht verliert während der Vortrocknung ihre Klebrigkeit, und ihr Restlösemittelgehalt wird während dieses Behandlungsschritts erfindungsgemäß auf 1 bis 30 Gewichtsprozent, bevorzugt auf 5 bis 20 Gewichtsprozent, insbesondere auf 8 bis 12 Gewichtsprozent, jeweils bezogen auf das Trockengewicht der Schicht eingestellt.

Der beschichtete Träger wird anschließend in bekannter Weise mittels aktinischer Strahlung, insbesondere UV-Strahlung, durch geeignete Masken, Negative, Schablonen, usw. bildmäßig belichtet.

Als nächstes werden die mit dem Photoresistgemisch beschichteten und belichteten Schichtträger in eine wäßrigalkalische Entwicklerlösung getaucht. Die Lösung wird vorzugsweise stark bewegt, was zum Beispiel durch Durchblasen von Stickstoff erfolgen kann. Als Entwickler sind beispielsweise wäßrige Alkali-, Ammonium- oder Tetramethylammoniumhydroxidlösungen geeignet, doch kann auch jeder andere bekannte geeignete Entwickler verwendet werden. Die Träger bleiben im Entwicklerbad, bis die Photoresistschicht an den belichteten Stellen ganz oder wenigstens fast ganz abgelöst ist.

Nach dem Herausnehmen der beschichteten Wafer aus der Entwicklerlösung kann eine Wärmenachbehandlung bzw. Einbrennbehandlung durchgeführt werden, um die Haftung und die chemische Beständigkeit der Schicht gegen Ätzlösungen und andere Substanzen zu erhöhen. Die Wärmebehandlung nach dem Entwickeln kann aus einer Ofenhärtung von Schicht und Träger unterhalb des Erweichungspunktes der Schicht bestehen. Sie wird beispielsweise bei Temperaturen von 95 bis 160 °C, bevorzugt von 95 bis 150 °C, insbesondere von 112 bis 120 °C, durchgeführt. Diese Wärmebehandlung kann ebenfalls mit einem Heizplattensystem durchgeführt werden; ihre Dauer liegt dann zwischen etwa 10 Sekunden und der für die Vernetzung des Harzes nötigen Zeitspanne. In der Regel sind dies etwa 10 bis 90 Sekunden, bevorzugt etwa 30 bis 90 Sekunden, insbesondere 15 bis 45 Sekunden. Die Behandlung kann die Dauer von 90 Sekunden auch überschreiten, doch führt dies im allgemeinen nicht zu einer weiteren Verbesserung des Ergebnisses. Im Trockenschrank dauert dieser Behandlungsschritt länger. Die benötigte Zeit hängt von der jeweiligen genauen Schichtzusammensetzung und dem verwendeten Schichtträger ab.

Für industrielle Anwendungen, insbesondere bei der Herstellung von Halbleiterbauelementen auf Siliciumträgern mit einer Siliciumdioxidschicht können die entwickelten Träger mit einer gepufferten Ätzlösung auf der Basis von Flußsäure oder mit Gasplasma behandelt werden. Die erfindungsgemäßen Photoresistgemische sind gegen derartige Ätzlösungen auf Säurebasis und gegen Plasmaätzen resistent und gewährleisten einen wirksamen Schutz der unbelichteten, mit dem Photoresistgemisch beschichteten Stellen des Schichtträgers.

In den folgenden Beispielen werden die Verfahren zur Herstellung und Anwendung von erfindungsgemäßen Gemischen eingehend erläutert. Diese Beispiele sollen jedoch die Erfindung in keiner Weise in ihrem Umfang beschränken, und sie sollen nicht dahingehend ausgelegt werden, daß sie Bedingungen, Parameter oder andere Werte angeben, die zur praktischen Ausführung der Erfindung ausschließlich anzuwenden sind.

Beispiel

Aus den folgenden Bestandteilen wurden Resistansätze hergestellt:
23,8 % harzartiges Bindemittel (Cresol/Formaldehyd-Novolak);
7,0 % lichtempfindliche Verbindung (Kondensationsprodukt aus 1,2-Diazonaphthochinon-5-sulfonylchlorid und 2,3,4-Trihydroxybenzophenon; und
69,2 % Lösemittelgemisch (PGME/PGMEA-Gemische in den in der nachstehenden Tabelle angegebenen Mischungsverhältnissen).

Das Absorptionsvermögen der Photoresists betrug in allen Fällen 1,33 ± 0,03 l/g•cm.

Durch entsprechende Einstellung der Aufschleudergeschwindigkeit wurden die Gemische so aufgetragen, daß nach einer Vortrocknung im Umluftschrank bei 90 °C während 30 Minuten eine Schichtdicke von 2,0 µm erhalten wurde. Die Schichtdicke wurde mit einem Rudolph-Schichtdickenmeßgerät ermittelt. Lichtempfindlichkeit und Kontrastwerte wurden mittels Laserinterferometrie bestimmt, und die erhaltenen Meßwerte wurden einer linearen Regression unterzogen, wobei die Regressionskurve durch 8 Meßpunkte geführt wurde.

Die Entwicklung erfolgte in allen Fällen mit "AZ Photoresist Developer", Herst. American Hoechst Corp., Somerville, NJ. USA, der mit Wasser im Verhältnis 1:1 verdünnt wurde.

Die Beispiele zeigen, daß mit den PGME/PGMEA-Gemischen Photoresists hergestellt werden können, die eine deutlich verringerte Geruchsbelästigung mit sich bringen, während sie in bezug auf Lichtempfindlichkeit und Kontrastwerte Photoresists entsprechen, zu deren Herstellung nur ein einziges Lösemittel, nämlich PGMEA, verwendet wurde.

TABELLE

| Verhältnis PGME:PGMEA | Harz | Schichtdicke (/um) | Aufschleuder- geschwindigkeit (U/min) | Kontrast | Veränderung der Lichtemp- lichkeit (1)% |
|---|---|---|---|---|---|
| A. 9:1 | Novolak | 2,073 | 6000 | 3,5 | + 3,9 |
| 9:1 | Novolak | 2,073 | 6000 | 3,5 | - 3,0 |
| B. 1:1 | Novolak | 2,067 | 5000 | 3,5 | + 1,3 |
| 1:1 | Novolak | 2,095 | 5000 | 3,5 | - 4,5 |
| C. 1:9 | Novolak | 1,999 | 4250 | 2,9 | + 8,2 |
| 1:9 | Novolak | 2,062 | 4250 | 2,9 | + 1,5 |
| D. 0:1 | Novolak | 2,055 | 3750 | 3,7 | - |

(1) Vergleichsresist: Lösemittel PGMEA

$$LE = \frac{LE_{Beispiel} - LE_{Vergleichsresist}}{LE_{Vergleichsresist}} \cdot 100\%$$

**Patentansprüche für die Vertragsstaaten: DE, FR, GB, IT, NL und AT**

1. Strahlungsempfindliches positiv-arbeitendes Gemisch, das im wesentlichen aus mindestens einem wasserunlöslichen, in wäßrig-alkalischen Lösungen löslichen Novolak- oder Polyvinylphenolharz als Bindemittel, mindestens einem o-Chinondiazid als lichtempfindlicher Verbindung und einem Propylenglykolalkyletheracetat enthaltendem Lösemittel besteht, dadurch gekennzeichnet, daß das Lösemittel ein Gemisch aus Propylenglykol-($C_1$–$C_4$)alkyletheracetat und Propylenglykol-($C_1$–$C_4$)-alkylether in einem Mischungsverhältnis zwischen 10:1 und 1:10 enthält oder daraus besteht.

2. Strahlungsempfindliches Gemisch nach Anspruch 1, dadurch gekennzeichnet, daß das Lösemittel ein Gemisch aus Propylenglykolmethyletheracetat und Propylenglykolmethylether enthält oder daraus besteht.

3. Strahlungsempfindliches Gemisch nach Anspruch 1, dadurch gekennzeichnet, daß das Lösemittel ein Gemisch aus Propylenglykolalkyletheracetat und Propylenglykolalkylether in einer Menge von etwa 5 bis 100 Gewichtsprozent, bezogen auf das Lösemittel, enthält.

4. Strahlungsempfindliches Gemisch nach Anspruch 1, dadurch gekennzeichnet, daß Propylenglykolalkylethersacetat und Propylenglykolalkylether in einem Mischungsverhältnis von etwa 1 : 1 Gewichtsteilen vorhanden sind.

5. Strahlungsempfindliches, positiv-arbeitendes Photoresistmaterial aus einem Schichtträger und einer darauf befindlichen Photoresistbeschichtung, die im wesentlichen aus einem Gemisch von mindestens einem wasserunlöslichen, in wäßrig-alkalischen Lösungen löslichen Novolak- oder Polyvinylphenolharz als Bindemittel, mindestens einem o-Chinondiazid als lichtempfindlicher Verbindung und einem Propylenglykolalkyletheracetat enthaltendem Lösemittel besteht, dadurch gekennzeichnet, daß die Beschichtung durch Vortrocknen eines Gemisches hergestellt wurde, dessen Lösemittel ein Gemisch aus Propylenglykol($C_1$-$C_4$)-alkyletheracetat und Propylenglykol-($C_1$-$C_4$)-alkylether in einem Mischungsverhältnis zwischen 10:1 und 1:10 enthält oder daraus besteht.

## EP 0 220 645 B1

### Patentansprüche für die Vertragsstaaten: CH, LI

1. Strahlungsempfindliches positiv-arbeitendes Gemisch, das im wesentlichen aus mindestens einem wasserunlöslichen, in wäßrig-alkalischen Lösungen löslichen Novolak- oder Polyvinylphenolharz als Bindemittel, mindestens einem o-Chinondiazid als lichtempfindlicher Verbindung und einem Propylenglykolalkyletheracetat enthaltendem Lösemittel besteht, dadurch gekennzeichnet, daß das Lösemittel ein Gemisch aus Propylenglykol-($C_1$-$C_4$)-alkyletheracetat und Propylenglykol-($C_1$-$C_4$)-alkylether enthält oder daraus besteht.

2. Strahlungsempfindliches Gemisch nach Anspruch 1, dadurch gekennzeichnet, daß das Lösemittel ein Gemisch aus Propylenglykolmethyletheracetat und Propylenglykolmethylether enthält oder daraus besteht.

3. Strahlungsempfindliches Gemisch nach Anspruch 1, dadurch gekennzeichnet, daß das Lösemittel ein Gemisch aus Propylenglykolalkyletheracetat und Propylenglykolalkylether in einer Menge von etwa 5 bis 100 Gewichtsprozent, bezogen auf das Lösemittel, enthält.

4. Strahlungsempfindliches Gemisch nach Anspruch 1, dadurch gekennzeichnet, daß Propylenglykolalkyletheracetat und Propylenglykolalkylether in einem Mischungsverhältnis von etwa 1 : 1 Gewichtsteilen vorhanden sind.

5. Strahlungsempfindliches, positiv-arbeitendes Photoresistmaterial aus einem Schichtträger und einer darauf befindlichen Photoresistbeschichtung, die im wesentlichen aus einem Gemisch von mindestens einem wasserunlöslichen, in wäßrig-alkalischen Lösungen löslichen Novolak- oder Polyvinylphenolharz als Bindemittel, mindestens einem o-Chinondiazid als lichtempfindlicher Verbindung und einem Propylenglykolalkyletheracetat enthaltendem Lösemittel besteht, dadurch gekennzeichnet, daß die Beschichtung durch Vortrocknen eines Gemisches hergestellt wurde, dessen Lösemittel ein Gemisch aus Propylenglykol-($C_1$-$C_4$)-alkyletheracetat und Propylenglykol-($C_1$-$C_4$)-alkylether enthält oder daraus besteht.

### Claims for the contracting states: DE, FR, GB, IT, NL, AT

1. Radiation-sensitive positive-working mixture which is composed essentially of at least one waterinsoluble novolak resin or polyvinylphenol resin which is soluble in aqueous alkaline solutions, as binder, at least one o-quinone diazide as photosensitive compound and a solvent containing propylene glycol alkyl ether acetate, characterized in that the solvent contains a mixture of propylene glycol ($C_1$–$C_4$)alkyl ether acetate and propylene glycol ($C_1$–$C_4$)alkyl ether in a mixing ratio of between 10:1 and 1:10 or is composed thereof.

2. Radiation-sensitive mixture according to Claim 1, characterized in that the solvent contains a mixture of propylene glycol methyl ether acetate and propylene glycol methyl ether or is composed thereof.

3. Radiation-sensitive mixture according to Claim 1, characterized in that the solvent contains a mixture of propylene glycol alkyl ether acetate and propylene glycol alkyl ether in an amount of about 5 to 100% by weight, based on the solvent.

4. Radiation-sensitive mixture according to Claim 1, characterized in that propylene glycol alkyl ether acetate and propylene glycol alkyl ether are present in a mixing ratio of about 1:1 parts by weight.

5. Radiation-sensitive positive-working photoresist material composed of a film base and a photoresist coating situated thereon which is composed essentially of a mixture of at least one water-insoluble novolak resin or polyvinylphenol resin, which is soluble in aqueous alkaline solutions, as binder, at least one o-quinone diazide as photosensitive compound and a solvent containing propylene glycol alkyl ether acetate, characterized in that the coating has been prepared by predrying a mixture the solvent of which contains a mixture of propylene mixture, the solvent of which contains glycol ($C_1$–$C_4$)alkyl ether acetate and propylene glycol ($C_1$–$C_4$)alkyl ether in a mixing ratio of between 10:1 and 1:10 or is composed thereof.

### Claims for the contracting states: CH, LI

1. Radiation-sensitive positive-working mixture which is composed essentially of at least one waterinsoluble novolak resin or polyvinylphenol resin which is soluble in aqueous alkaline solutions, as binder, at least one o-quinone diazide as photosensitive compound and a solvent containing propylene glycol alkyl ether acetate, characterized in that the solvent contains a mixture of propylene glycol ($C_1$–$C_4$)alkyl ether acetate and propylene glycol ($C_1$–$C_4$)alkyl ether or is composed thereof.

2. Radiation-sensitive mixture according to Claim 1, characterized in that the solvent contains a mixture of propylene glycol methyl ether acetate and propylene glycol methyl ether or is composed thereof.

3. Radiation-sensitive mixture according to Claim 1, characterized in that the solvent contains a mixture of propylene glycol alkyl ether acetate and propylene glycol alkyl ether in an amount of about 5 to 100% by weight, based on the solvent.

4. Radiation-sensitive mixture according to Claim 1, characterized in that propylene glycol alkyl ether acetate and propylene glycol alkyl ether are present in a mixing ratio of about 1:1 parts by weight.

5. Radiation-sensitive positive-working photoresist material composed of a film base and a photoresist coating situated thereon which is composed essentially of a mixture of at least one water-insoluble novolak resin or polyvinylphenol resin, which is soluble in aqueous alkaline solutions, as binder, at least one o-quinone diazide as photosensitive compound and a solvent containing propylene glycol alkyl ether acetate, characterized in that the coating has been prepared by predrying a mixture, the solvent of which contains a mixture of propylene glycol $(C_1–C_4)$alkyl ether acetate and propylene glycol $(C_1–C_4)$alkyl ether or is composed thereof.

## Revendications pour les Etats Contractants: DE, FR, GB, IT, NL, AT

1. Composition sensible aux radiations, travaillant en positif, essentiellement constituée d'au moins, en tant que liant, une résine Novolaque ou polyvinylphénolique insoluble dans l'eau, soluble dans des solutions aqueuses-alcalines, d'au moins un o-quinonediazide en tant que composé photosensible, et d'un solvant contenant un acétate d'éther alkylique de propylèneglycol, caractérisée en ce que le solvant contient ou consiste en un mélange d'acétate d'éther alkylique en $C_1–C_4$ de propylèneglycol et d'éther alkylique en $C_1–C_4$ de propylèneglycol, en un rapport de mélange compris entre 10:1 et 1:10.

2. Composition sensible aux radiations selon la revendication 1, caractérisée en ce que le solvant contient ou consiste en un mélange d'acétate d'éther méthylique de propylèneglycol et d'éther méthylique de propylèneglycol.

3. Composition sensible aux radiations selon la revendication 1, caractérisée en ce que le solvant contient un mélange d'acétate d'éther alkylique de propylèneglycol et d'éther alkylique de propylèneglycol en une quantité d'environ 5 à 100% en poids, par rapport au solvant.

4. Composition sensible aux radiations selon la revendication 1, caractérisée en ce que l'acétate d'éther alkylique de propylèneglycol et l'éther alkylique de propylèneglycol sont présents en un rapport de mélange d'environ 1:1 parties en poids.

5. Matériau de photoresist sensible aux radiations, travaillant en positif, composé d'un support de couche et d'un revêtement de photoresist se trouvant sur celui-ci, essentiellement constitué d'un mélange d'au moins, en tant que liant, une résine Novolaque ou polyvinylphénolique insoluble dans l'eau, soluble dans des solutions aqueusesalcalines, d'au moins un o-quinonediazide en tant que composé photosensible, et d'un solvant contenant un acétate d'éther alkylique de propylèneglycol, caractérisé en ce que le revêtement a été produit par pré-séchage d'une composition qui, en tant que solvant, contient ou consiste en un mélange d'acétate d'éther alkylique en $C_1–C_4$ de propylèneglycol et d'éther alkylique en $C_1–C_4$ de propylèneglycol, en un rapport de mélange compris entre 10:1 et 1:10.

## Revendications pour les Etats Contractants: CH, LI

1. Composition sensible aux radiations, travaillant en positif, essentiellement constituée d'au moins, en tant que liant, une résine Novolaque ou polyvinylphénolique insoluble dans l'eau, soluble dans des solutions aqueuses-alcalines, d'au moins un o-quinonediazide en tant que composé photosensible, et d'un solvant contenant un acétate d'éther alkylique de propylèneglycol, caractérisée en ce que le solvant contient ou consiste en un mélange d'acétate d'éther alkylique en $C_1–C_4$ de propylèneglycol et d'éther alkylique en $C_1–C_4$ de propylèneglycol.

2. Composition sensible aux radiations selon la revendication 1, caractérisée en ce que le solvant contient ou consiste en un mélange d'acétate d'éther méthylique de propylèneglycol et d'éther méthylique de propylèneglycol.

3. Composition sensible aux radiations selon la revendication 1, caractérisée en ce que le solvant contient un mélange d'acétate d'éther alkylique de propylèneglycol et d'éther alkylique de propylèneglycol en une quantité d'environ 5 à 100% en poids, par rapport au solvant.

4. Composition sensible aux radiations selon la revendication 1, caractérisée en ce que l'acétate d'éther alkylique de propylèneglycol et l'éther alkylique de propylèneglycol sont présents en un rapport de mélange d'environ 1:1 parties en poids.

5. Matériau de photoresist sensible aux radiations, travaillant en positif, composé d'un support de couche et d'un revêtement de photoresist se trouvant sur celui-ci, essentiellement constitué d'un mélange d'au moins, en tant que liant, une résine Novolaque ou polyvinylphénolique insoluble dans l'eau, soluble dans des solutions aqueusesalcalines, d'au moins un o-quinonediazide en tant que composé photosensible, et d'un solvant contenant un acétate d'éther alkylique de propylèneglycol, caractérisé en ce que le revêtement a été produit par pré-séchage d'une composition qui, en tant que solvant, contient ou consiste en un mélange d'acétate d'éther alkylique en $C_1–C_4$ de propylèneglycol et d'éther alkylique en $C_1–C_4$ de propylèneglycol.